(19) Europäisches Patentamt
European Patent Office
Office européen des brevets

(11) **EP 1 014 616 A2**

(12) **EUROPEAN PATENT APPLICATION**

(43) Date of publication:
**28.06.2000 Bulletin 2000/26**

(51) Int Cl.[7]: **H04L 7/033**, H03L 7/00

(21) Application number: **99310177.3**

(22) Date of filing: **17.12.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **22.12.1998 US 218053**

(71) Applicant: **NORTEL NETWORKS CORPORATION**
**Montreal, Quebec H2Y 3Y4 (CA)**

(72) Inventors:
• **Habel, Richard Achille**
  **Kanata, Ontario K2K 2N5 (CA)**

• **Betts, Malcolm C.**
  **Kanata, Ontario K2W 1A7 (CA)**
• **Kennedy, Chris Brendan**
  **Nepean, Ontario K2H 9M5 (CA)**
• **Solheim, Alan Glen**
  **Kanata, Ontario K2M 1C4 (CA)**

(74) Representative: **Maury, Richard Philip et al**
**Sommerville & Rushton,**
**Business Link Building,**
**45 Grosvenor Road**
**St. Albans, Herts AL1 3AW (GB)**

(54) **Apparatus and method for versatile digital communication**

(57)     A simple phase locked loop (PLL) operates over a broad continuous range of frequencies, a range much larger than one octave but requires only an octave VCO. The Q of the PLL is controlled to within a factor of two at every frequency on the broad continuous range. The PLL enables the invention of a clock recovery circuit that operates at any bit-rate on a broad, continuous range of bit-rates. The bit-rate independent clock recovered by the PLL has equivalent jitter performance at all bit-rates. The PLL may be used to provide 3R transponder/regenerators with read/write access to over-head data, eye quality assessment, monitoring/identification of the bit-rate of the signal, and with bit-rate independent digital multiplexing and demultiplexing functions. Such a 3R transponder/regenerator may also enable addition of overhead data to the digital signal, independent of the format or bit-rate of the digital signal. Bit-rate independent digital multiplexing and demultiplexing enable the interconnection of electronics in the 3R transponder/regenerator, or provision of digital signals to other functional blocks, at the lower demultiplexed bit-rate.

FIGURE 2

EP 1 014 616 A2

## Description

## FIELD OF THE INVENTION

This invention is directed to a phase locked loop (PLL), and more particularly to a frequency agile PLL for bit rate independent 3R transponders.

## BACKGROUND OF THE INVENTION

Telecommunications network providers are feeling the competing pressures of ever-increasing demand for capacity, as well as the need to offer new and additional services flexibly and quickly.

The need to quickly and cost-effectively provide increased capacity, along with the reality of fiber congestion in the network, is causing service providers to search for a solution that will increase capacity without forcing them to deploy additional fibers. At the moment, two practical solutions exist: using wavelength division multiplexing (WDM) to combine multiple wavelengths on one set of fibers, and/or using time division multiplexing (TDM) systems that operate at a higher channel rate.

The need to be able to offer new services flexibly and quickly over the fiber plant is causing service providers to search for a transmission solution that is not limited to any specific protocol or bit-rate. Digital transparency is becoming valuable - service providers are searching for ways to create channels over optical fibers that can carry a range of bit-rates and protocols. But service providers would prefer not to give-up performance for transparency.

Improvements in optical transmission methods have vastly enhanced the use of optical communication systems by increasing the distance over which optical signals are transmitted. However, performance requirements still demand regenerating equipment spaced at regular intervals, so that as the network grows, both in terms of number of wavelengths and in distance, the number of regenerators also grows.

Highest performance regenerators are 3R: they not only reshape and regenerate the signal, they also retime it. But the retime function is traditionally bit-rate specific, so networks that require highest performance, and hence 3R regenerators, are not transparent to the rate of the digital signal. While retiming improves system performance, because it is traditionally bit-rate specific, in networks where digital transparency is required, 3R regenerators could not be used. Less valuable 2R, or even 1R regenerators, are deployed in a network instead of 3R, because they are bit-rate independent, but the important re-time function is forsaken. (1R type is only for regenerating the signal, 2R type reshapes and regenerates the signal). On the other hand, if system performance is paramount, 3R regenerators have traditionally been deployed and digital transparency abandoned.

The 3R transponder operates similarly to the 3R regenerator, with the difference that a transponder also performs wavelength conversion. A 3R transponder is used at sites where the transmission signal needs to be converted from one wavelength to another, for example from 1310μm to a wavelength on the ITU grid suitable for dense WDM. This is typically the case at the on-ramp and off-ramp of WDM networks. Current 3R transponders, just as 3R regenerators, are bit-rate dependent.

It is advantageous, and in many cases unavoidable, to use 3R regenerators/transponders. For example, 1R and 2R regenerators/transponders cannot reset jitter, a phenomenon which degrades a digital signal as it propagates through a network. By re-timing the digital signal, the 3R regenerator/transponder resets jitter, resulting in much more reliable and robust service, and very much longer reach.

The retime function of 3R regenerators/transponders is also referred to as clock recovery. Besides jitter reset, there are other benefits of clock recovery in a regenerator/transponder. Phase-aligning a local clock to the digital signal allows assessment of the eye-quality of the digital signal by sampling it over a range of clock phases. This is an important network performance monitoring tool. 1R and 2R regenerators/ transponders cannot offer it, since it requires a clock aligned with the data.

Furthermore, the clock needs to be recovered whenever the signal must be accessed. Thus, phase-aligning a local clock to the digital signal allows sampling of the digital signal and even changing it. For example, once the clock is available, access to the overhead of the digital signal is also available, which means that all of the OAM&P operations offered by the protocol being carried are accessible.

Yet another benefit of clock recovery is the ability to demultiplex and again multiplex the digital signal. Demultiplexing the single serial line rate digital signal in to multiple parallel lower rate signals allows less expensive lower rate regenerator/transponder circuitry, and allows the digital signal to be distributed locally over low frequency interconnect lines. Both the demultiplexing and requisite multiplexing operation require a clock phase-aligned with the digital signal.

Still another benefit of 3R regeneration is its termination of in-band overhead. In-band overhead is frequently implemented as low amplitude modulation of the optical carrier. This low amplitude modulation leaks through 1R and 2R regenerators/transponders, which means, where 1R or 2R regenerators/transponders are deployed, this overhead vehicle cannot be used for overhead functionality that is intended to terminate at regenerators/transponders. 3R regenerators/transponders essentially receive an incoming signal, and recreate it; they effectively terminate any low-amplitude signalling on the incoming signal.

So, there is, more and more, the desire by service providers to offer digitally transparent channels over their optical network - in general, over an on-ramp transponder, through one or more regenerators, and over an off-ramp transponder. Where 1R or 2R transponders/regenerators have been deployed instead of 3R, because digital transparency has been required, all of the above benefits have been forsaken. What is required is a digitally transparent 3R regenerator/transponder - a regenerator/transponder that offers all of the above advantages, and is protocol and bit-rate independent, too. This reduces to the requirement for bit-rate independent clock recovery.

It is known to recover the clock using synchronisers comprised of one or more phase locked loops (PLL). A PLL is a circuit used to lock a local oscillator to operate with a constant phase angle relative to the external clock carried by the client signal.

Current PLL's could operate at more than one frequency. This is obtained by use of dividers and multipliers at the output of the local oscillator. However, such a PLL operates only at frequencies that are integer multiples of one another. For example, there are IC's offered commercially that operate only at integer-multiple SONET/SDH frequencies 155.5MHz, 622.1MHz, 1244MHz and 2488MHz.

These types of PLL's may be used to design regenerators and transponders that work at bit-rates that are integer multiples of one another, such as, for example, an OC-3/OC-12/OC-48 transponder or regenerator. Problems arise when attempting to phase lock signals of various frequencies that are not integer multiples of each-other, using a same PLL. These types of PLLs are called frequency-agile (or frequency independent) PLLs.

The current frequency agile PLLs are implemented with comb generators that produce a plurality of discrete, regularly spaced output frequencies. A particular output is then selected with a band-pass filter. Evidently, the filter must be changed according to the frequency of interest. In addition, comb generators are complex and expensive circuits.

## SUMMARY OF THE INVENTION

It is an object of the present invention to provide a frequency agile PLL that alleviates totally or in part the drawbacks associated with the current PLLs.

It is another object of the invention to provide a frequency agile PLL capable of clock recovery over a broad continuous range of bit-rates.

Still another object of the present invention is to provide a bit-rate transparent transponder, regenerator or receiver that requires one clock recovery circuit only, while it works on a broad and continuous range of bit-rates.

According to the present invention, there is provided a frequency agile phase looked loop (PLL) comprising a voltage controlled oscillator (VCO) for receiving a control voltage and generating a signal So in a frequency range;

a plurality N of dividers connected in series, each divider n for receiving an upstream signal $S_{n-1}$, dividing the frequency of signal $S_{n-1}$ by a factor $d^n$, and providing a signal $S_n$, a selector for receiving all the $N+1$ signals provided by the VCO and the dividers, and selecting a recovered clock signal of a frequency of interest, a phase error detector for receiving an input signal and the recovered clock signal and determining a phase error signal, and a loop filter for receiving the phase error signal and providing the control voltage, where $n$ is the index of the divider, and is an integer taking values between 1 and N, and $d$ is the divide ratio of each the divider.

According to a further aspect of the invention there is provided a bit rate independent receiver for recovering the clock of a digitally modulated electrical input signal having any bit rate within a provisioned range, comprising a frequency agile PLL for receiving the input signal and extracting therefrom a recovered clock signal and a data recovery unit for receiving the recovered clock and the input signal and retrieving a recovered signal corresponding to a channel of interest according to the recovered clock signal.

In a further embodiment of the invention there is provided a bit rate independent optical receiver for a 3R regenerator or transponder comprising an optical-to-electrical converter for converting a digitally modulated optical client signal of any bit rate in a provisioned range into an electrical input signal a frequency agile PLL for receiving the input signal and extracting therefrom a recovered clock, a data recovery unit for receiving the recovered clock and the input signal and retrieving a recovered signal corresponding to a channel of interest according to the recovered clock signal, and a control unit for determining the type of the input signal and controlling the frequency agile PLL to select the recovered clock in conformity with the type of the input signal.

In yet a further embodiment of the invention there is provided a method for recovering the clock of a digitally modulated input signal of any bit rate in a provisioned range using a frequency agile PLL, comprising generating a signal $S_o$ in a provisioned frequency range according to a control voltage, connecting a plurality $N$ of dividers in series, a first divider to receive the signal $S_o$, and at each divider $n$, dividing the frequency of an upstream signal $S_{n-1}$ by a factor $d^n$; selecting a recovered clock signal of a frequency of interest out of all the signals $S_0$ to $S_N$, determining a phase error signal by phase comparing the input signal and the recovered clock signal, and filtering the phase error signal to provide the control voltage, where $n$ is the index of the divider, and is an integer taking values between 1 and N, and $d$ is the divide ratio of each the divider.

An advantage of the frequency agile PLL according to the invention is that it is capable of recovering a broad continuous range of bit-rates. This PLL circuit is simple, and there is no conceptual limit on the range.

The only limit on the range is the cost and availability of the electronic components required to support the highest end of the range.

Still another advantage of the invention is that it provides for a simple design for the clock recovery circuitry of a bit-rate and protocol independent 3R receiver, regenerator, or transponder, which requires only one PLL to retime a client signal presented to it. In addition, the PLL may be used for digital and analog networks.

Still another advantage is that the PLL lock mechanism is able to indicate to the system the bit rate of the data, without any condition being placed on the data format other than Non Return to Zero (NRZ) and DC balance.

A further advantage of the invention is that it provides for the design of a 3R transponder that is capable of the insertion of transport overhead that is independent of the client signal bit-rate or protocol.

**BRIEF DESCRIPTION OF THE DRAWINGS**

The foregoing and other objects, features and advantages of the invention will be apparent from the following more particular description of the preferred embodiments, as illustrated in the appended drawings, where:

> **Figure 1** is a block diagram of a prior art PLL;
> **Figure 2** shows the block diagram of the frequency agile PLL according to the invention;
> **Figure 3** illustrates an amplitude-frequency graph showing the transfer characteristic of the PLL, the jitter tolerance and jitter transfer graphs; and
> **Figure 4** shows a bit-rate and protocol independent 3R regenerator or 3R transponder.

**DESCRIPTION OF THE PREFERRED EMBODIMENT**

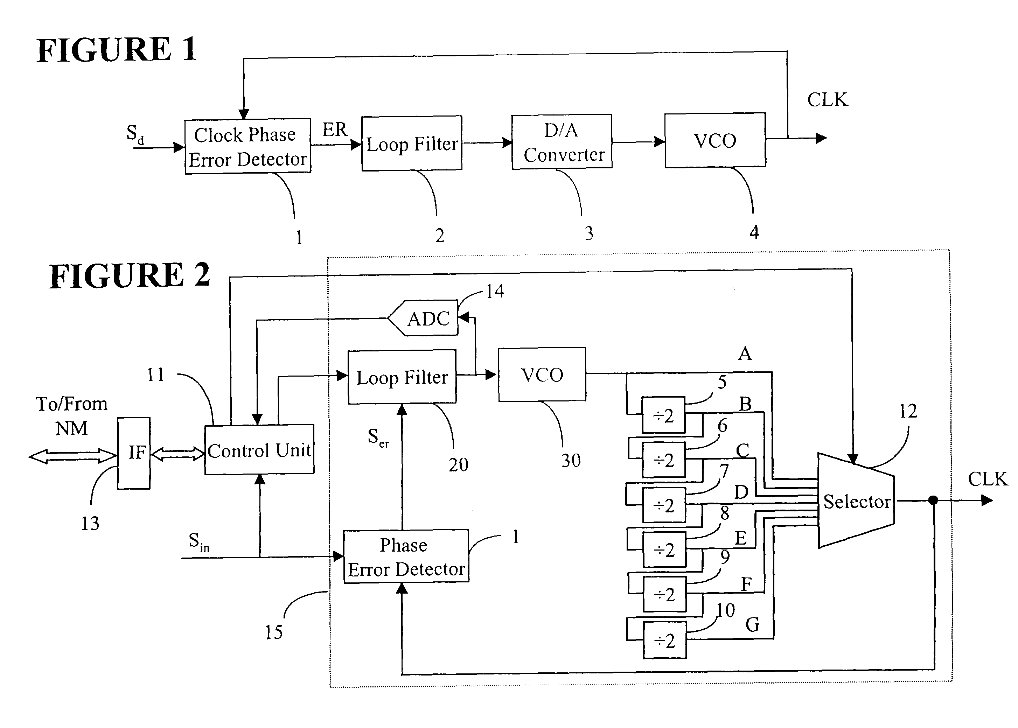

Various circuits for recovering the clock carried within a signal travelling over a communication network have been proposed. Figure 1 shows one of such conventional PLLs for recovering a reference clock CLK from a digitally modulated signal. The PLL comprises a clock phase error detector **1**, a loop filter **2**, a D/A converter **3**, and a voltage controlled oscillator (VCO) **4**. The VCO outputs the reference clock signal CLK. The clock phase error detector receives the demodulated digital signal $S_d$ comprising the clock to be recovered, and the reference clock CLK, detects a phase difference between these two clock signals and outputs the phase difference, or the phase error signal ER in a digital format. This signal is input to the loop filter **2**, where the high frequency components are removed from the output in accordance with the low-pass characteristics of this filter. The signal output by the loop filter is converted into an analog signal by the D/A converter **3**, which in turn effects a fine control of the frequency of oscillation of VCO **4** to align it to the clock from the demodulated digital signal $S_d$. An alternative implementation has an analog clock phase error detector and loop filter, and thus does not require any D/A converter.

As it can be readily understood, this conventional PLL is designed for recovering one narrow range of frequencies only.

The block diagram of the frequency agile PLL **15** according to the invention is shown in Figure 2. PLL **15** is designed to recover a clock of any frequency on a broad continuous range, from any type of digitally modulated signal.

The circuit uses an octave VCO (voltage controlled oscillator) **30** in combination with a cascade of clock dividers **5 - 10**. Figure 2 shows six dividers-by-two used for the preferred embodiment, but the number of dividers is not limited to 6; more or less of them may be used, according to the frequency range necessary for a certain application.

Since the VCO **30** can span an octave of frequencies, and the reference clock output by the VCO **30** is divided in frequency by two, four, eight, sixteen, etc., any frequency can be generated at the outputs of the dividers.

Selector **12** selects a frequency of interest as the recovered clock signal. The selection can be done in hardware or in software.

Figure 2 also shows a control unit **11** used to set the programmable gains for loop filter **20** and control selector **12.** Control unit **11** determines the type of the signal presented at the input of the PLL to instruct selector **12** to choose the value of interest for the recovered clock corresponding to that type of signal. Also, when PLL **15** is used in the receiver unit of a regenerator or a transponder, control unit **11** can be connected to the communication network using an interface shown at **13**, to transmit to the network manager (not shown) information regarding the type of the detected signal, along with the timing information. An optional analog to digital converter **14** is shown which may be used to monitor the VCO control voltage to facilitate estimation of the bit-rate of the recovered clock.

Control unit also achieves lock acquisition by monitoring the input and output signals.

The range of frequencies on which the PLL may lock is much larger than one octave, the PLL nevertheless requiring only an octave VCO. For example, VCO **30** may operate over the range 2.5GHz±33%. The rate for STS-48 (SONET) or STM-16 (SDH) of 2488MHz is in this frequency range and would be available at input A of selector **12.** Input B in this case spans the frequency range 2.5GHz÷2±33%, which is 1.25GHz±33%. The SONET/SDH STS-24/STM-8 rate of 1244MHz is on this frequency range and would be available at input B of selector **12.** The SONET/SDH STS-12/STM-4 rate would be available at input C, etc. Very importantly, the PLL **15** may also be locked on other, non-SONET/SDH rates in these octave ranges. As examples, both 1062MHz (fiber channel) and 1600MHz (serial HIPPI) are frequencies on the range available at input B of selector **12**, while 565MHz (PDH) is a frequency on the range available at input C, and 44.736MHz (DS-3) is a frequency on the range available at input G of selector **12**.

The PLL bandwidth, K, is determined according to equation 1:

$$K = K_d \, K_o \, K_h \, / d^n \qquad \text{(EQ(1)}$$

where $K_d$ is the gain of the phase detector, $K_o$ is the VCO gain, $K_h$ is the loop filter gain, and $d^n$ is the ratio for a divider n (e.g. 1, 2, 4, 8, 16, etc.). $n \in [0, N]$, $N$ is the number of dividers, and d is the ratio of all dividers, which is 2 in the example of Figure 2. $d$ was selected 2 in accordance with the use of an octave VCO.

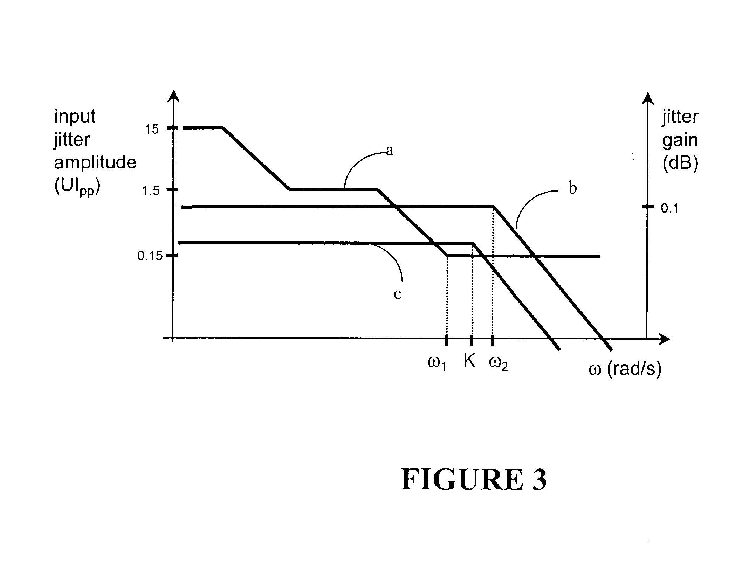

Figure 3 is an amplitude (dB) - frequency (rad/s) diagram showing a typical jitter tolerance mask **a**, jitter transfer characteristic **b**, and PLL transfer characteristic c. In order to satisfy the jitter tolerance requirement, the PLL BW K must exceed $\omega_1$, while in order to satisfy the jitter transfer requirement, the PLL BW K must be less than $\omega_2$. $\omega_1$ and $\omega_2$ are defined by equations 2 and 3:

$$\omega_1 = \omega_o / 2500 \qquad \text{EQ(2)}$$

$$\omega_2 = 2 \times \omega_1 \qquad \text{EQ(3)}$$

where $\omega_o$ is the frequency to which the PLL is to be locked.

Evidently, jitter transfer and jitter tolerance requirements are not mutually exclusive. There is a range of PLL BW's, $\omega_1 < K < \omega_2$, a factor of two (an octave), on which both requirements are satisfied.

The frequency agile PLL **15** is compliant with the jitter specifications illustrated in Figure 3 and defined by equations EQ(2) and EQ(3) for K designed as per equation 4:

$$K = \omega_{vco} / 1875 \qquad \text{RQ(4)}$$

where $\omega_{vco}$ is the VCO **30** center frequency (e.g. if the VCO operates on the range 2.5GHz ±33%, its center frequency is 2.5GHz). This is true for every frequency on the broad continuous range of frequencies spanned by the frequency agile PLL **15.** This is because, having designed the PLL bandwidth K as per equation EQ(4), when the VCO **30** is operated at any frequency on its octave operating range, K explores the allowed octave range defined by equations EQ(2) and EQ(3), but does not exceed it. It is also because, if the frequency to which the PLL is to be locked is not on the range of the VCO **30**, so that one of the divider outputs is to be utilised, K is reduced by a factor of two for every divider **5-10** (d=2), keeping K on the allowed range defined by equations 2 and 3. This dependence of K on divider setting is evident from equation 1.

The Q of a PLL is the ratio of the frequency of operation to the bandwidth. When the VCO **30** is an octave VCO and d=2, the frequency agile PLL has Q that is intrinsically maintained to within a factor of two at every frequency on the broad continuous range, even without active PLL loop gain control. For example, if the PLL was designed to have a BW of 1 MHz with-respect-to input A of selector **12**, its BW with-respect-to input C would be 250kHz (1MHz÷4), and its BW with-respect-to input E would be 62.5kHz (250kHz÷4). In other words, each divider, which reduces the instantaneous frequency by a factor of 2, also reduces the PLL BW by 2, so that Q, the ratio of these two parameters, remains fixed. It is this fixed value of Q, a feature of the frequency agile PLL **15**, which results in the PLL having equivalent jitter performance at all bit-rates on the broad continuous range of frequencies available at the output of selector **12.**

Because this PLL topology intrinsically controls Q, it is capable of satisfying even the stringent jitter specifications required for transmission over optical fiber, such as those recommended in Bellcore GR-253.

In fact the Q of the PLL **15** is intrinsically maintained to within a factor of two only ideally. Practically, any change in value of any one or more of the parameters in equation EQ(1) in turn alters the PLL Q. To guarantee compliance to jitter specifications, the Q of the PLL needs to be maintained in spite of component tolerances. To achieve this it is possible to use a programmable loop filter **20** in the PLL, which delivers a high degree of bandwidth control over the entire frequency range, in combination with the intrinsic BW reduction obtained because of the clock dividers. A loop filter with four programmable gains is the preferred embodiment. Using a programmable loop filter with just four programmable gains, the jitter specifications defined by equations 2 and 3 can be met with PLL component gain tolerances of as high as ±25%. In fact any of the PLL components that impact its gain may be made programmable, not strictly the loop filter as per this preferred embodiment.

The frequency agile PLL **15** may be used, most generally, to design a bit-rate independent receiver - a single receiver which can extract the clock from any digital signal, irrespective of the bit-rate, over a broad continuous range of bit-rates. Bit-rate independent clock recovery is enabled by the frequency agile PLL, which in turn enables the bit-rate independent receiver.

More specifically, the frequency agile PLL **15** may be used to design a bit-rate and protocol independent 3R regenerator or 3R transponder.

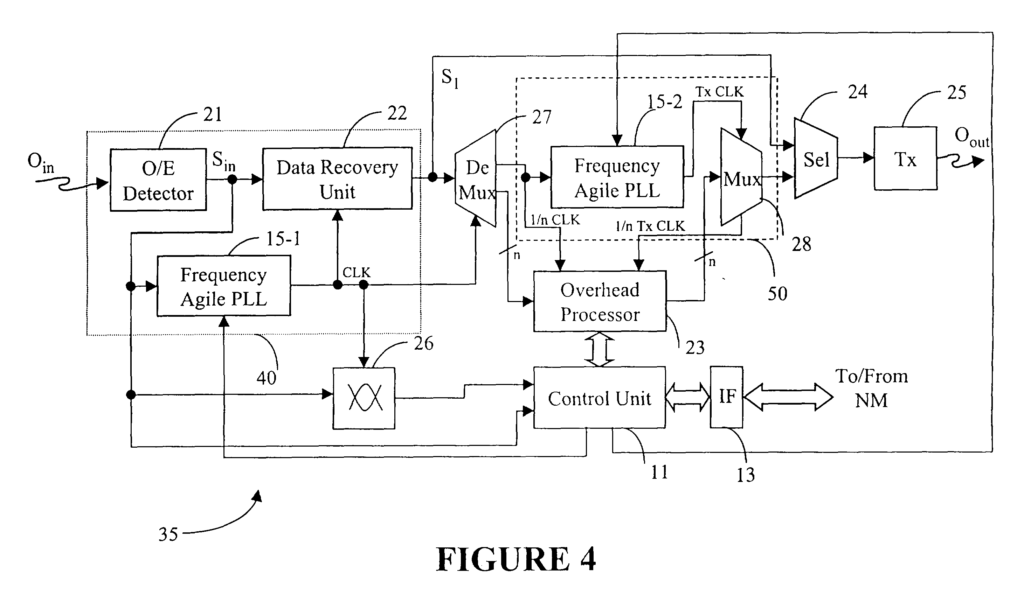

Figure 4 illustrates a block diagram of a bit-rate and protocol independent 3R regenerator or 3R transponder **35** comprising an optical receiver **40** and an optical transmitter **25**. An optical signal O$_{in}$ is converted into an electrical signal S$_{in}$ in optical to electrical converter **21**, which is applied to data recovery unit **22**, for regeneration of the client signal. The recovered signal is denoted in Figure 4 with S$_1$. As in Figure 2, control unit **11** determines the type of the input signal and accordingly tunes selector **12** and sets the programmable gains of loop filter **20** of frequency agile PLL **15-1**. Control unit also communicates to the network management information of interest about the detected signal S$_1$ over interface **13**.

Figure 4 shows frequency agile PLL **15-1** on the receiving side of the 3R transponder/regenerator **35**, and also shows a multiplexing section **50** equipped with a transmitter side frequency agile PLL **15-2**. Section **50** is shown in dotted lines being optional, and its operation will be described later.

Because of the well-controlled Q of the frequency agile PLL **15**, as explained in detail above, the so-designed 3R transponder/regenerator features equivalent (high-quality) jitter performance at any bit-rate over the broad continuous range of bit-rates spanned.

Having recovered a local clock, the 3R transponder/regenerator of Figure 4 can feature overhead access. An overhead processor **23** can be included in the 3R transponder/regenerator to facilitate read/write overhead access - that is, the overhead data may be monitored only, or it may be monitored and also modified. In this context, it is the overhead content embedded in the protocol of the digital signal being carried that is accessed. The overhead processor **23** may be designed to recognize and access a variety of data protocols.

Having recovered a local clock, the 3R transponder/regenerator according to the invention can also feature eye quality assessment capability. Figure 4 shows an eye diagram assessment circuit **26**. The phase of the recovered clock can be adjusted and used to explore the shape of the digital eye, on copies of the recovered electrical signal S$_{in}$. This eye quality information is very important for network performance monitoring. In Figure 4, eye quality information is shown being communicated to the control unit **11**.

Such a bit-rate and protocol independent 3R transponder/regenerator can feature bit-rate reporting and bit-rate limiting, two very useful network operations features. The bit-rate monitoring feature may be used by the network operator to offer differentiated billing - billing based on the capacity (bit-rate) of the digital signal a customer is passing over the network. The bit-rate limiting feature can be used to enforce such tolls; the so-designed 3R transponder/regenerator, while capable of operating at particular high bit-rates, could be provisioned to restrict carriage of high bit-rate services to customers who have this privilege. The control unit **11** can estimate and report to network management software the bit-rate of the carried signal based on the selector **12** setting, and VCO **30** control voltage (the ADC **14** on Figure 2 is used for VCO control voltage monitoring). The control unit **11** can also restrict the use of one or more of the highest frequency channels of selector **12.**

Having recovered a local clock, the 3R transponder/regenerator **35** of the invention can demultiplex (demultiplexer **27**) the high bit-rate serial data stream into multiple lower bit-rate parallel data streams. These are inexpensively routed within a circuit pack, and also are more easily routed among circuit packs over a backplane, not requiring high-speed interconnect strategies. While transmission rates are as high as 10Gbps today, and are expected to increase, conventional backplane data rates are considerably lower. Conventional backplanes can hence be used to support the 3R transponder/regenerator **35.** The features that low-speed interconnect enable are many, including electrical bandwidth management, such as switching, across multiple channels, and protection switching in the electrical domain.

While only one PLL **15** is necessary for operation of transponder/regenerator **35**, a second PLL **15-2** may be used to reduce jitter transfer. The bandwidth of the frequency agile PLL **15-2** of the transmit-side of the transponder/regenerator **35** is, in this scenario, designed to be much narrower than the bandwidth of the receive-side PLL. PLL **15-2** is also required to clock demultiplexed data into the multiplexer **28**.

In Figure 4, selector **24** gives the option to transmit either the recovered data S$_1$ directly, or the processed data stream that results after demultiplexing **27**, processing **23**, and multiplexing **28.**

It should also be noted that the bit-rate and protocol independent 3R regenerator or 3R transponder can utilise low-level signalling on the input optical signal to identify the client signal and thereby select the appropriate input of selector **12** (see Figure 2). Also, while the use of such low-level signalling for carriage of in-band overhead information is known, a problem with it is that it leaks through 1R and 2R regenerator/transponders. A 3R regenerator/transponder effectively terminates this overhead so that it can be used to carry information intended to terminate at the regenerator or transponder.

An additional feature that a bit-rate and protocol independent 3R transponder may offer is bit-rate and protocol independent overhead. This is in contrast to the feature where the recovered signal S$_1$ is input to an overhead processor that is capable of recognising a set of standard data protocols. Rather, a transponder equipped with a frequency agile PLL **15** can add/subtract locally generated overhead data, independent of the protocol of the data signal being carried. In concept, such a transponder would wrap the client signal, independent of its bit-rate or protocol, in a network specific overhead wrapper.

The preferred embodiment of such a transponder would have a clock and data recovery section **40,** including the frequency agile PLL **15,** which recovers data and clock. The data stream would next be demultiplexed in demultiplexer **27**. The recovered clock CLK is passed to a multiplex section **50** which generates a transmit clock Tx CLK that is synchronised with the recovered clock but of slightly higher frequency. The multiplex section **50** passes a divided-down version of this transmit clock to an overhead processor (which could be overhead processor **23** or a separate one) to which the demultiplexed data is also passed. The overhead processor creates a new frame structure using the transmit clock, maps the data onto this frame structure, adds overhead, and sends the modified data stream to the multiplex section. The multiplex section receives the modified data stream and multiplexes it to create a new higher rate serial data stream - a data stream now with additional transport overhead data added.

The preceding description was of the on-ramp transponder where overhead is added to an input data signal. The inverse is done at the off-ramp transponder.

The bit-rate and protocol independent 3R regenerator or 3R transponder have many applications. The transponder will be key in optical networks where transparent interfaces are required. Transponders would be situated on the periphery of the optical network, performing the on-ramp and off-ramp functions, mapping any client digital signal onto one of the optical network channels (on-ramp), or converting the data from one of the optical network channels back to the client digital signal format (off-ramp). The most sophisticated of such transponders would insert their own overhead to facilitate operation of the optical network, overhead that is completely independent of the protocol and bit-rate of the client signals being transported, overhead to implement such powerful features as forward error correction (FEC). The same optical network would utilise the bit-rate and protocol independent 3R regenerator to extend its reach. Such an optical network would be as high performance as today's fixed bit-rate optical networks, and feature transparent interfaces also.

## Claims

1. A frequency agile phase looked loop (PLL) comprising:

   a voltage controlled oscillator (VCO) for receiving a control voltage and generating a signal $S_o$ in a frequency range;
   a plurality $N$ of dividers connected in series, each divider n for receiving an upstream signal $S_{n-1}$, dividing the frequency of signal $S_{n-1}$ by a factor $d^n$, and providing a signal $S_n$;
   a selector for receiving all said $N+1$ signals provided by said VCO and said dividers, and selecting a recovered clock signal of a frequency of interest;
   a phase error detector for receiving an input signal and said recovered clock signal and determining a phase error signal; and
   a loop filter for receiving said phase error signal and providing said control voltage,
   where $n$ is the index of said divider, and is an integer taking values between 1 and N, and $d$ is the divide ratio of each said divider.

2. A frequency agile PLL as claimed in claim 1, wherein said VCO frequency range is substantially an octave and $d$=2.

3. A frequency agile PLL as claimed in claim 1, wherein said loop gain is programmable with at least four programmable gains.

4. A bit rate independent receiver for recovering the clock of a digitally modulated electrical input signal having any bit rate within a provisioned range, comprising:

   a frequency agile PLL for receiving said input signal and extracting therefrom a recovered clock signal; and
   a data recovery unit for receiving said recovered clock and said input signal and retrieving a recovered signal corresponding to a channel of interest according to said recovered clock signal.

5. A receiver as claimed in claim 4 further comprising an optical-to-electrical converter for converting an optical client signal into said electrical input signal.

6. A receiver as claimed in claim 4, further comprising a control unit for determining the type of said input signal and controlling said frequency agile PLL to select said recovered clock in conformity with the type of said input signal.

7. A receiver as claimed in claim 4, further comprising a control unit for determining the type of said input signal and providing said frequency agile PLL with a plurality of programmable gains in conformity with the type of said input signal.

8. A receiver as claimed in claim 7, further comprising a network interface for providing a network manager with information regarding the type of said client signal.

9. A receiver as claimed in claim 4, further comprising an overhead processor for accessing the overhead of said recovered signal for maintenance purposes.

10. A receiver as claimed in claim 4, further comprising eye quality assessment equipment for receiving said recovered signal and said recovered clock and preparing an eye diagram of said recovered signal.

**11.** A bit rate independent optical receiver for a 3R regenerator or transponder comprising:

an optical-to-electrical converter for converting a digitally modulated optical client signal of any bit rate in a provisioned range into an electrical input signal;
a frequency agile PLL for receiving said input signal and extracting therefrom a recovered clock;
a data recovery unit for receiving said recovered clock and said input signal and retrieving a recovered signal corresponding to a channel of interest according to said recovered clock signal; and
a control unit for determining the type of said input signal and controlling said frequency agile PLL to select said recovered clock in conformity with the type of said input signal.

**12.** A method for recovering the clock of a digitally modulated input signal of any bit rate in a provisioned range using a frequency agile PLL, comprising:

generating a signal $S_o$ in a provisioned frequency range according to a control voltage;
connecting a plurality $N$ of dividers in series, a first divider to receive said signal $S_o$, and at each divider $n$, dividing the frequency of an upstream signal $S_{n-1}$ by a factor $d^n$;
selecting a recovered clock signal of a frequency of interest out of all said signals $S_0$ to $S_N$;
determining a phase error signal by phase comparing said input signal and said recovered clock signal; and
filtering said phase error signal to provide said control voltage,
where $n$ is the index of said divider, and is an integer taking values between 1 and N, and $d$ is the divide ratio of each said divider.

**13.** A method as claimed in claim 12, wherein all said signals $S_0$ to $S_N$ have equivalent jitter performance.

**14.** A method as claimed in claim 12, wherein the Q of said PLL for each signal $S_n$, which is the ratio of the frequency of said recovered clock to the PLL bandwidth for said signal $S_n$, is controlled to be within a factor of two.

**15.** A method as claimed in claim 12, further comprising converting an optical digitally modulated input signal to said input signal.

**16.** A method as claimed in claim 15, further comprising determining the type of said input signal and controlling said frequency agile PLL to select said recovered clock in conformity with the type of said input signal.

**17.** A method as claimed in claim 16, further comprising providing a network manager with information regarding the type of said client signal.

**18.** A method as claimed in claim 12 for controlling said frequency agile PLL for limiting the range of said PLL in conformity with a user profile.

**19.** A method as claimed in claim 12, further comprising separating said input signal from a multichannel input signal according to said recovered clock signal.

**20.** A method as claimed in claim 12, further comprising providing said input signal with a universal overhead for indicating at least type, rate, address and error information on said signal.

**21.** A method as claimed in claim 20, further comprising accessing the overhead of said recovered signal for network OAM&P purposes.

# FIGURE 1

# FIGURE 2

EP 1 014 616 A2

**FIGURE 3**

**FIGURE 4**

EP 1 014 616 A2